# EUROPEAN PATENT APPLICATION

(11) **EP 4 661 155 A2**
(43) Date of publication of application: **10.12.2025**
(21) Application number: 25180319.3
(22) Date of filing: 03.06.2025
(51) Int. Cl.: H01M 10/42, H01M 10/48, H01M 10/54

(54) **METHOD FOR ESTIMATING BATTERY CATHODE CAPACITY AND BATTERY RECYCLING SYSTEM USING THE SAME**

(30) Priority: 04.06.2024 KR 20240073350
(71) Applicant: SAMSUNG SDI CO., LTD., Yongin-si, Gyeonggi-do 17084 (KR)
(72) Inventor: KIM, Minsoo, 17084 Yongin-Si Gyeonggi-do (KR); KWON, Moon-Seok, 17084 Yongin-Si Gyeonggi-do (KR); KA, Bokhyun, 17084 Yongin-si, Gyeonggi-do (KR)
(74) Representative: Gulde & Partner

(57) **Abstract**

A processor-implemented method for estimating a cathode capacity of a battery and a battery recycling system utilizing the method are provided. A processor-implemented method for estimating a cathode capacity of a battery includes receiving first discharge data associated with a first discharge rate of a battery, receiving second discharge data associated with a second discharge rate of the battery, receiving third discharge data associated with a third discharge rate of the battery, and estimating the cathode capacity of the battery based on the first discharge rate, the second discharge rate, the third discharge rate, the first discharge data, the second discharge data, and the third discharge data, where the first discharge rate, the second discharge rate, and the third discharge rate may be different from each other.

## Description

### BACKGROUND

### 1. Field

Aspects of one or more embodiments of the present disclosure relate to a method for estimating the cathode capacity of a battery based on discharge data of the battery, and a battery recycling system utilizing the same.

### 2. Description of the Related Art

Unlike primary batteries that are not designed to be (re)charged, secondary (or rechargeable) batteries are batteries that are designed to be discharged and recharged. Lowcapacity secondary batteries are utilized in portable, small electronic devices, such as smart phones, feature phones, notebook computers, digital cameras, and camcorders, while largecapacity secondary batteries are widely utilized as power sources for driving motors in hybrid vehicles and electric vehicles and for storing power (e.g., home power storage and/or utility scale power storage). A secondary battery generally includes an electrode assembly composed of a cathode and an anode, a case accommodating the same, and electrode terminals connected to the electrode assembly.

As the demand for batteries including secondary batteries increases, the battery recycling industry is also becoming important. A variety of battery recycling methods may be applied depending on the remaining service life when recycling batteries. Therefore, identifying the degradation state of the cathode or anode in a battery may be important for effective recycling of the battery.

The above information disclosed in this Background section is for enhancement of understanding of the background of the present disclosure, and therefore, it may contain information that does not constitute related (or prior) art.

### SUMMARY

It may be desirable to diagnose the internal state of a battery non-destructively in order to identify the degradation state of the cathode or anode of the battery. Although charge/discharge data may be utilized to diagnose the internal state of a battery, it is difficult to isolate and determine only the degradation of the cathode or anode from the charge/discharge data of the battery. In a comparative example, the internal state of a battery may be diagnosed after dismantling the battery. However, such techniques may have the inconvenience of having to dismantle the cells to diagnose the internal state of a battery, and thus, even normal cells may be discarded if dismantled.

One or more embodiments of the present disclosure may be direct toward a method for estimating the cathode capacity of a battery, and a battery recycling system utilizing the method. The method is a computer-implemented method (e.g. processor-implemented method).

These and other aspects and features of the present disclosure will be described in or will be apparent from the following description of embodiments of the present disclosure.

According a first aspect of the present disclosure, a processor-implemented method for estimating a cathode capacity of a battery, carried out by a processor (e.g. at least one processor) includes receiving first discharge data associated with a first discharge rate of a battery, receiving second discharge data associated with a second discharge rate of the battery, receiving third discharge data associated with a third discharge rate of the battery, and estimating a cathode capacity of the battery based on the first discharge rate, the second discharge rate, the third discharge rate, the first discharge data, the second discharge data, and the third discharge data, where the first discharge rate, the second discharge rate, and the third discharge rate may be different from each other.

According to some embodiments of the present disclosure, the first discharge rate may include a maximum discharge rate of the battery.

According to some embodiments of the present disclosure, each of the discharge data (e.g., the first discharge data, the second discharge data, and the third discharge data) may include a discharge capacity of a battery full-cell associated with each of the discharge rates (e.g., the first discharge rate, the second discharge rate, and the third discharge rate, respectively).

According to some embodiments of the present disclosure, the first discharge rate, the second discharge rate, and the third discharge rate may be rates greater than or equal to a proportion (e.g., a predetermined proportion) of a maximum discharge rate of the battery.

According to some embodiments of the present disclosure, the estimating of the cathode capacity of the battery may include estimating a linear function representing a relationship between a discharge rate of the battery and a discharge capacity of a battery full-cell based on the first discharge rate, the second discharge rate, the third discharge rate, the first discharge data, the second discharge data, and the third discharge data.

According to some embodiments of the present disclosure, the estimating of the cathode capacity of the battery may further include calculating a first determination coefficient based on the first discharge rate, the second discharge rate, the third discharge rate, the first discharge data, the second discharge data, and the third discharge data, and determining whether the first determination coefficient is greater than or equal to a threshold (e.g., a predetermined threshold).

According to some embodiments of the present disclosure, the estimating of the cathode capacity of the battery may further include receiving fourth discharge data associated with a fourth discharge rate for the battery in response to determining that the first determination coefficient is less than the threshold (e.g., a predetermined threshold), calculating a second determination coefficient *R*² based on the first discharge rate, the second discharge rate, the fourth discharge rate, the first discharge data, the second discharge data, and the fourth discharge data, and determining whether the second determination coefficient is greater than or equal to the threshold (e.g., a predetermined threshold), and the third discharge rate may be less than the first discharge rate, the second discharge rate, and the fourth discharge rate.

According to some embodiments of the present disclosure, the estimating of the cathode capacity of the battery may further include calculating the cathode capacity of the battery based on the linear function.

According to some embodiments of the present disclosure, the linear function may be estimated via an extrapolation.

According to some embodiments of the present disclosure, a cathode of the battery may include lithium iron phosphate (LFP).

According to some embodiments of the present disclosure, the method may further include determining a recycling method for a cathode of the battery based on the estimated cathode capacity of the battery.

According to some embodiments of the present disclosure, the determining of the recycling method for the cathode of the battery may include determining that the estimated cathode capacity of the battery is greater than or equal to a threshold (e.g., a predetermined threshold), and transmitting a command to perform a direct recycling of the cathode of the battery to a battery recycling device in response to the determining that the estimated cathode capacity of the battery is greater than or equal to the threshold (e.g., a predetermined threshold).

According to some embodiments of the present disclosure, the determining of the recycling method for the cathode of the battery may include determining that the estimated cathode capacity of the battery is less than a threshold (e.g., a predetermined threshold), and transmitting a command to perform pyrometallurgy or hydrometallurgy on the cathode of the battery to a battery recycling device in response to the determining that the estimated cathode capacity of the battery is less than the threshold (e.g., a predetermined threshold).

According to one or more embodiments of the present disclosure, a program stored in a computer-readable recording medium for executing a method for estimating a cathode capacity of a battery on a computer may be provided.

A second aspect of the present disclosure relates to a battery recycling system, which includes a memory and a processor (e.g. at least one processor) connected to the memory and configured to execute instructions stored in the memory to cause the processor to perform the above described processor-implemented method including: receiving first discharge data associated with a first discharge rate for a battery, receiving second discharge data associated with a second discharge rate for the battery, receiving third discharge data associated with a third discharge rate for the battery, and estimating a cathode capacity of the battery based on the first discharge rate, the second discharge rate, the third discharge rate, the first discharge data, the second discharge data, and the third discharge data, and where the first discharge rate, the second discharge rate, and the third discharge rate may be different from each other.

According to some embodiments of the present disclosure, the first discharge rate may include a maximum discharge rate of the battery.

According to some embodiments of the present disclosure, each of the discharge data (the first discharge data, the second discharge data, and the third discharge data) may include a discharge capacity of a battery full-cell associated with each of the discharge rates (the first discharge rate, the second discharge rate, and the third discharge rate, respectively).

According to some embodiments of the present disclosure, the estimating the cathode capacity of the battery may include estimating a linear function representing a relationship between a discharge rate of the battery and a discharge capacity of a battery full-cell based on the first discharge rate, the second discharge rate, the third discharge rate, the first discharge data, the second discharge data, and the third discharge data.

According to some embodiments of the present disclosure, the estimating the cathode capacity of the battery may further include calculating a determination coefficient based on the first discharge rate, the second discharge rate, the third discharge rate, the first discharge data, the second discharge data, and the third discharge data, and determining whether the determination coefficient is greater than or equal to a threshold (e.g., a predetermined threshold).

According to some embodiments of the present disclosure, the battery recycling system may further include a battery recycling device, where the at least one program may further include instructions for determining a recycling method for a cathode of the battery based on the estimated cathode capacity of the battery, and transmitting a command related to the determined recycling method to the battery recycling device.

According to some embodiments of the present disclosure, the battery recycling system further comprises a battery recycling device, wherein the instructions cause the (e.g. one or more) processor to perform the above-mentioned method, which further comprises determining a recycling method for a cathode of the battery based on the estimated cathode capacity of the battery, and transmitting a command related to the determined recycling method to the battery recycling device.

According to some embodiments of the present disclosure, the cathode capacity of the battery may be estimated based on data on the discharge capacities of the battery full-cell associated with different discharge rates. As a result, the cathode capacity of the battery may be estimated utilizing the discharge data on the battery full-cell without dismantling or disassembling the battery.

However, aspects and features of the present disclosure are not limited to those described above, and other aspects and features not mentioned will be clearly understood by a person skilled in the art from the detailed description, described below.

### BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings.
FIG. 1 is a schematic diagram of a battery recycling system in accordance with some embodiments of the present disclosure;
FIG. 2 is a block diagram showing the internal configuration of a processor in accordance with some embodiments of the present disclosure;
FIG. 3 shows an example of a charge/discharge capacity graph of an anode half-cell in accordance with some embodiments of the present disclosure;
FIG. 4 shows an example of a charge/discharge capacity graph of a cathode half-cell in accordance with some embodiments of the present disclosure;
FIG. 5 shows an example of a discharge capacity graph at a low-rate discharge of an anode half-cell, a cathode half-cell, and a full-cell in accordance with some embodiments of the present disclosure;
FIG. 6 shows an example of a discharge capacity graph at a high-rate discharge of an anode half-cell, a cathode half-cell, and a full-cell in accordance with some embodiments of the present disclosure;
FIG. 7 is a graph showing an example of discharge data of a full-cell and a half-cell in accordance with some embodiments of the present disclosure;
FIG. 8 is a flowchart showing an example of a method for estimating a cathode capacity in accordance with some embodiments of the present disclosure;
FIG. 9 is a flowchart showing an example of a step of estimating a cathode capacity of a battery in accordance with some embodiments of the present disclosure; and
FIG. 10 is a flowchart showing an example of a process for determining a recycling method for a battery cathode in accordance with some embodiments of the present disclosure.

### DETAILED DESCRIPTION

Hereinafter, embodiments of the present disclosure will be described, in detail, with reference to the accompanying drawings. The terms or words utilized in this specification and claims should not be construed as being limited to the usual or dictionary meaning and should be interpreted as meaning and concept consistent with the technical idea of the present disclosure based on the principle that the inventor may be his/her own lexicographer to appropriately define the concept of the term to explain his/her disclosure in the best way.

The embodiments described in this specification and the configurations shown in the drawings are only some of the embodiments of the present disclosure and do not represent all of the technical ideas, aspects, and features of the present disclosure. Accordingly, it should be understood that there may be one or more equivalents and modifications that may replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of one or more elements, layers, etc. may be exaggerated for clarity of illustration. The same reference numerals designate the same elements. As utilized herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are utilized to designate a list of elements A, B and C, the phrase may refer to any and all suitable combinations or a subset of A, B and C, such as A, B, C, A and B, A and C, B and C, or A and B and C. As utilized herein, the terms "use," "using," and "used" may be considered synonymous with the terms "utilize," "utilizing," and "utilized," respectively. As utilized herein, the terms "substantially," "about," and similar terms are utilized as terms of approximation and not as terms of degree, and are intended to account for the inherent variations in measured or calculated values that would be recognized by those of ordinary skill in the art.

It will be understood that, although the terms first, second, third, etc. may be utilized herein to describe one or more elements, components, regions, layers, and/or sections, these elements, components, regions, layers, and/or sections should not be limited by these terms. These terms are utilized to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be utilized herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors utilized herein should be interpreted accordingly.

The terminology utilized herein is for the purpose of describing embodiments of the present disclosure and is not intended to be limiting of the present disclosure. As utilized herein, the singular forms "a" and "an" are intended to include the plural forms as well, unless the context clearly indicates otherwise. It will be further understood that the terms "have/has/having," "include/includes/including," and/or "comprise/comprises/comprising," when utilized in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges would comply with the requirements of 35 U.S.C. § 112(a) and 35 U.S.C. § 132(a).

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may be disposed/arranged in contact with the upper (or lower) surface of the element, and another element may also be interposed between the element and the arbitrary element disposed/arranged on (or under) the element.

In addition, it will be understood that when a component is referred to as being "linked," "coupled," or "connected" to another component, the elements may be directly "coupled," "linked" or "connected" to each other, or another component may be "interposed" between the components".

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

Singular expressions herein include plural expressions, unless the context clearly specifies that they are singular. Further, plural expressions include singular expressions, unless the context clearly specifies that they are plural. When a part is said to include a component throughout the specification, this does not mean to exclude other components but may mean to further include other components unless specifically stated to the contrary.

Further, the term "module" or "part" as utilized herein refers to a software or hardware component, and the "module" or "part" performs certain roles. However, the "module" or "part" does not carry a meaning limited to software or hardware. The "module" or "part" may be configured to reside on an addressable storage medium or may be configured to run one or more processors. Therefore, by way of example, the "module" or "part" may include at least one of components such as software components, object-oriented software components, class components, and task components, processes, functions, properties, procedures, subroutines, segments of program code, drivers, firmware, microcode, circuitry, data, databases, data structures, tables, arrays, or variables. The functionality provided within components and "modules" or "parts" may be combined into fewer components and "modules" or "parts," or may be further divided into additional components and "modules" or "parts."

According to some embodiments of the present disclosure, the "module" or "part" may be implemented with a processor and a memory. The "processor" should be construed broadly to encompass general-purpose processors, central processing units (CPUs), microprocessors, digital signal processors (DSPs), controllers, microcontrollers, state machines, etc. In some contexts, the "processor" may refer to application-specific integrated circuits (ASICs), programmable logic devices (PLDs), field programmable gate arrays (FPGAs), etc. The "processor" may also refer to a combination of processing devices such as, for example, a combination of a DSP and a microprocessor, a combination of a plurality of microprocessors, a combination of one or more microprocessors in combination with a DSP core, or a combination of any other such components. Further, the "memory" should be construed broadly to encompass any electronic component capable of storing electronic information. The "memory" may also refer to one or more types of processor-readable media, such as random-access memory (RAM), read-only memory (ROM), non-volatile random-access memory (NVRAM), programmable read-only memory (PROM), erasable-programmable read-only memory (EPROM), electrically erasable PROM (EEPROM), flash memory, magnetic or optical data storage, registers, etc. A memory is said to be in electronic communication with a processor if the processor may read information from and/or write information to the memory. The memory integrated into a processor is in electronic communication with the processor.

In the present disclosure, a "system" may include at least one of a server device and a cloud device, but is not limited thereto. For example, the system may be formed of one or more server devices. As another example, the system may be formed of one or more cloud devices. As yet another example, the system may operate by being formed of a server device and a cloud device together.

In the present disclosure, the sizes and relative sizes of the areas shown in the drawings may have been exaggerated for clarity of description. For example, the sizes shown in the drawings are merely for ease of understanding and are not limited thereto. Further, the flowcharts shown in the drawings and the descriptions thereof are merely examples and may be implemented differently in some embodiments. For example, one or more steps may be omitted, the order of each step may be changed, one or more steps may be performed in an overlapping manner, or one or more steps may be performed repetitively multiple times.

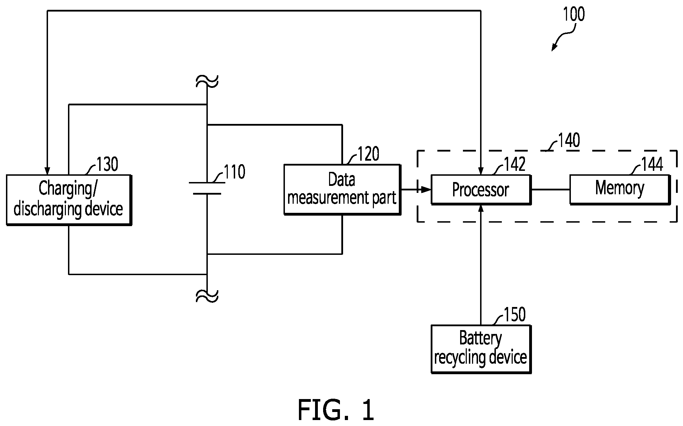

FIG. 1 is a schematic diagram of a battery recycling system 100 in accordance with some embodiments of the present disclosure.

Referring to FIG. 1, the battery recycling system 100 may include a battery 110, a data measurement part 120, a charging/discharging device 130, an information processing system 140, and a battery recycling device 150. The charging/discharging device 130 may include a charging device and a discharging device. The battery 110 may be charged or discharged by the charging/discharging device 130. For example, the battery 110 may be inside (e.g., disposed/arranged inside) an electronic device and may be charged or discharged by a charging/discharging device included in the electronic device or an external charging/discharging device. Referring to FIG. 1, the battery 110 is shown as being connected only to the charging/discharging device 130 and the data measurement part 120, but is not limited thereto. For example, the battery 110 may be electrically connected to external components. The battery 110 may supply electric power to the external components while charging, or may supply electric power to the external components after charging is completed. In some embodiments, the battery 110 may be electrically connected to another component (e.g., the battery recycling device 150) after being separated from the data measurement part 120 and the charging/discharging device 130.

The charging/discharging device 130 may charge or discharge the battery 110 by one or more (e.g., by varying) charge/discharge rates (C-rates). Here, the charge/discharge rate may be a value obtained by dividing the magnitude of the charge/discharge current of the battery by the rated capacity of the battery. For example, the discharging device may discharge the battery 110 at a first discharge rate. Further, the discharging device may discharge the battery 110 at a second discharge rate different from the first discharge rate. For example, the second discharge rate may be slower than the first discharge rate. Moreover, the battery 110 may be charged by the charging device before the discharging device discharges the battery 110.

In some embodiments, the first discharge rate may be less than or equal to a threshold (e.g., a predetermined threshold). Here, the threshold may be 1 C. Here, C is a unit of discharge rate, and may mean a discharge rate at which it takes a corresponding amount of time (e.g., a certain amount of time) to fully discharge the corresponding battery. For example, a discharge rate of 1 C may mean a discharge rate at which it takes 1 hour to completely discharge a fully charged battery. As another example, a discharge rate of 0.5 C may mean a discharge rate at which it takes 2 hours to completely discharge a fully charged battery.

The data measurement part 120 may include a voltage sensor. While the battery 110 is being discharged by the discharging device, the voltage sensor may generate voltage data for the battery 110. The voltage data may include voltage data according to a discharge capacity obtained by discharging the battery 110. Based on the generated voltage data, the data measurement part 120 may generate discharge data. Here, the discharge data may include discharge capacity data associated with the discharge rate of the battery 110. The discharge capacity data may be data calculated based on the generated voltage data. The discharge capacity data may be calculated by the data measurement part 120 and/or a processor 142.

The discharge data may be transmitted to the processor 142 of the information processing system 140. In FIG. 1, the data measurement part 120 is shown as exchanging information with the information processing system 140 outside the information processing system 140, but is not limited thereto. For example, the data measurement part 120 may be included in the information processing system 140. The data measurement part 120 may generate discharge data for the battery 110 within the information processing system 140 and transmit it to the processor 142.

The information processing system 140 may include the processor 142 and a memory 144. The processor 142 may receive the discharge data associated with the discharge rate for the battery generated from the data measurement part 120. The processor 142 may estimate the cathode capacity of the battery 110 based on the received discharge data.

The processor 142 may determine a recycling method for the cathode of the battery 110 based on the estimated data on the cathode capacity of the battery 110. The processor 142 may transmit a command to perform the determined recycling method for the cathode of the battery 110 to the battery recycling device 150. The discharge data received by the processor 142, the data on the cathode capacity of the battery 110, the recycling method data for the cathode of the battery 110, etc., may be stored in the memory 144.

The battery recycling device 150 may receive the command to perform the recycling method for the cathode of the battery 110 determined by the processor 142 from the processor 142. The battery recycling device 150 may perform recycling of the cathode of the battery 110 based on the command received from the processor 142. Here, the recycling of the cathode of the battery 110 may be a method of extracting core raw material metals of the battery 110, such as lithium, nickel, cobalt, manganese, copper, and/or aluminum, from an already-used battery 110 and utilizing them for manufacturing a new battery. The battery recycling device 150 may be an automated device that extracts cathode materials from the already-used battery 110.

In some embodiments, the recycling method for the cathode of the battery 110 may include a direct recycling method, a pyrometallurgical method, a hydrometallurgical method, and/or the like. Battery recycling may mean disassembling a battery after use, extracting and utilizing valuable metals such as lithium, cobalt, and/or nickel, and reutilizing them as battery raw materials. The direct recycling method may refer to a method of recycling by physically separating the active material coated on the cathode of the battery. The direct recycling method may be less expensive and more environmentally friendly than the pyrometallurgical method and the hydrometallurgical method. The pyrometallurgical method may refer to a method of extracting metals in a manner of discharging and disassembling a used battery, crushing it, placing resulting flakes in a furnace, and melting them. The hydrometallurgical method may refer to a method of extracting metals by discharging and disassembling a used battery, crushing and pulverizing it to produce fine black powder, and then adding a solvent to the black powder to cause a chemical reaction.

In some embodiments, the charging/discharging device 130 and the processor 142 may communicate with each other. The processor 142 may transmit a command to adjust the discharge rate of the battery 110 to the discharging device in order to receive discharge data associated with the discharge rate of the battery 110. Further, the processor 142 may transmit a command to charge the battery 110 to the charging device in order to receive discharge data in the fully charged state of the battery 110.

Referring to FIG. 1, a single battery 110 is shown, but is not limited thereto. For example, a plurality of batteries may be discharged by the discharging device, and discharge data may be generated by the data measurement part 120. Further, the plurality of batteries may be charged to a fully charged state by the charging device.

Moreover, the information processing system 140 may further include a communication module. The communication module may provide a configuration or function for communicating with the charging/discharging device, the data measurement part, or the battery recycling device, and may provide a configuration or function for the information processing system 140 to communicate with external devices, external systems, etc. As one example, control signals, commands, data, and/or the like provided under the control of the information processing system 140 may be transmitted to the charging/discharging device, external devices, and/or external systems via the communication module, and control signals, commands, data, and/or the like provided by the charging/discharging device, external devices, and/or external systems may be transmitted via the communication module.

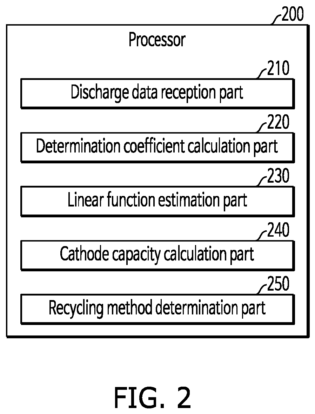

FIG. 2 is a block diagram showing the internal configuration of a processor in accordance with some embodiments of the present disclosure. The processor 200 may include a discharge data reception part 210, a determination coefficient calculation part 220, a linear function estimation part 230, a cathode capacity calculation part 240, and a recycling method determination part 250. For example, the processor 200 may be the processor 142 included in the information processing system 140 of FIG. 1.

In some embodiments, the discharge data reception part 210 may receive discharge data from a data measurement part (e.g., the data measurement part 120 of FIG. 1). For example, the discharge data reception part 210 may receive first discharge data associated with a first discharge rate for the battery, second discharge data associated with a second discharge rate for the battery, and third discharge data associated with a third discharge rate for the battery from the data measurement part.

In some embodiments, the first discharge rate, the second discharge rate, and the third discharge rate may be different from each other. For example, the first discharge rate may be faster than the second discharge rate. Further, the second discharge rate may be faster than the third discharge rate.

In some embodiments, the first discharge rate may be the maximum discharge rate of the battery. Here, the maximum discharge rate of the battery may be the maximum discharge rate allowed if (e.g., when) discharging the battery in view of the performance of the battery. For example, the maximum discharge rate of the battery may be 1 C, but is not limited thereto.

In some embodiments, the first discharge data associated with the first discharge rate may include data on the discharge capacity of the battery obtained by discharging the fully charged battery at the first discharge rate. The second discharge data associated with the second discharge rate may include data on the discharge capacity of the battery obtained by discharging the fully charged battery at the second discharge rate. The third discharge data associated with the third discharge rate may include data on the discharge capacity of the battery obtained by discharging the fully charged battery at the third discharge rate.

In some embodiments, the first discharge rate, the second discharge rate, and the third discharge rate may be rates greater than or equal to a proportion (e.g., a predetermined proportion) of the maximum discharge rate of the battery. For example, the first discharge rate, the second discharge rate, and the third discharge rate may be rates greater than or equal to a proportion (e.g., a predetermined proportion) of the maximum discharge rate allowed if (e.g., when) discharging the battery in view of the performance of the battery. For example, the maximum discharge rate of the battery may be 1 C, and the proportion may be 50%. In this case, the first discharge rate, the second discharge rate, and the third discharge rate may be 0.5 C or higher. However, the present embodiment is not limited thereto.

In some embodiments, each discharge data may include data on the discharge capacity of a battery full-cell associated with each discharge rate. The processor 200 may estimate the cathode capacity of the battery based on data on the discharge rate and the discharge capacity of the battery full-cell associated therewith, as will be described later. For example, the cathode capacity of the battery may be estimated utilizing data on the battery full-cell (e.g., the discharge rate and the discharge capacity of the battery full-cell) without dismantling and/or disassembling the battery in order to diagnose the internal state of the battery.

In some embodiments, the determination coefficient calculation part 220 may calculate a first determination coefficient (*R*²) based on each discharge rate for the battery and the discharge data associated therewith (e.g., discharge rate). Here, the determination coefficient may represent a measure of the degree to which an estimated linear model is suitable for given data. The determination coefficient may have a value between 0 and 1, and the higher the correlation between the dependent variable and the independent variable, the closer the value may be to 1. Therefore, the higher the determination coefficient, the higher the accuracy of the estimated linear model may be. At least three discharge data may be utilized if (e.g., when) calculating the first determination coefficient (*R*²).

In some embodiments, the determination coefficient calculation part 220 may determine whether the calculated first determination coefficient is greater than or equal to a threshold (e.g., a predetermined threshold). For example, the threshold may be 0.99, but is not limited thereto. In response to determining that the first determination coefficient is less than the threshold, the processor 200 may receive fourth discharge data associated with a fourth discharge rate for the battery. Accordingly, the determination coefficient calculation part 220 may calculate a second determination coefficient based on the first discharge rate, the second discharge rate, the fourth discharge rate, the first discharge data, the second discharge data, and the fourth discharge data. Further, the determination coefficient calculation part 220 may determine whether the second determination coefficient is greater than or equal to the threshold. Here, the third discharge rate may be less than the first discharge rate, the second discharge rate, and the fourth discharge rate. For example, in response to determining that the determination coefficient is less than the threshold, the determination coefficient calculation part 220 may calculate a determination coefficient based on a discharge rate higher than the lowest discharge rate and the discharge data associated therewith, instead of the lowest discharge rate and the discharge data associated therewith. This process may be performed until it is determined that the determination coefficient calculated based on three or more discharge rates and discharge data associated therewith is greater than or equal to the threshold.

In some embodiments, the linear function estimation part 230 may estimate a linear function representing a relationship between the discharge rate of the battery and the discharge capacity of the battery full-cell based on the first discharge rate, the second discharge rate, the third discharge rate, the first discharge data, the second discharge data, and the third discharge data. In the process of calculating the determination coefficient by the determination coefficient calculation part 220, n-th discharge data associated with an n-th discharge rate may be received by the processor 200 (where n is a natural number greater than or equal to 4). However, for convenience, the first, second, and third discharge rates and their related discharge data utilized in the linear function estimation part 230 may refer to the discharge rates and the discharge data associated therewith that are based on if (e.g., when) the determination coefficient is determined to be greater than or equal to the threshold (e.g., a predetermined threshold) by the determination coefficient calculation part 220.

The linear function estimation part 230 may estimate the linear function representing the relationship between the discharge rate of the battery and the discharge capacity of the battery full-cell via extrapolation. Extrapolation may be a method of estimating the value of a variable based on its relationship with other variables beyond the original observation range in mathematics. For example, it may be a method of estimating data values in a range that has not been collected based on the relationship of collected data values.

In some embodiments, the first discharge rate, the second discharge rate, and the third discharge rate may be rates greater than or equal to a proportion (e.g., a predetermined proportion) of the maximum discharge rate of the battery. For example, the maximum discharge rate of the battery may be 1 C, and the proportion may be 50%. Therefore, the first discharge rate, the second discharge rate, and the third discharge rate may be 0.5 C or higher, but are not limited thereto. Further, the cathode capacity of the battery may be estimated based on the discharge capacity of the battery full-cell associated with a discharge rate of 0 C. According to the above example, because the data collected by the processor 200 are discharge rates of 0.5 C or higher and the discharge data associated therewith, the linear function estimation part 230 needs to estimate the linear function representing the relationship between the discharge rate of the battery and the discharge capacity of the battery full-cell utilizing extrapolation in order to calculate the discharge capacity of the battery full-cell associated with the discharge rate of 0 C.

In some embodiments, the cathode capacity calculation part 240 may calculate the cathode capacity of the battery by utilizing the linear function representing the relationship between the discharge rate of the battery and the discharge capacity of the battery full-cell, estimated via the linear function estimation part 230.

In some embodiments, the cathode capacity of the battery may be calculated based on the discharge capacity of the battery full-cell associated with the discharge rate of 0 C via the estimated linear function.

In some embodiments, the cathode of the battery may include lithium iron phosphate (LFP). Further, the cathode of the battery may include LiCoPO₄, LiMnPO₄, LiNiPO₄, NaFePO₄, and/or composite materials thereof.

In some embodiments, the recycling method determination part 250 may determine a recycling method for the battery cathode based on the cathode capacity of the battery calculated by the cathode capacity calculation part 240. Specifically, the recycling method determination part 250 may determine whether the cathode capacity of the battery is greater than or equal to a threshold (e.g., the recycling method determination part 250 may determine that the cathode capacity of the battery is greater than or equal to a predetermined threshold), and may transmit a command to perform direct recycling of the battery cathode to the battery recycling device in response to that determining that the cathode capacity of the battery is greater than or equal to the threshold. In contrast, in response to determining that the cathode capacity of the battery is less than the threshold, a command to perform pyrometallurgy or hydrometallurgy on the battery cathode may be transmitted to the battery recycling device. For example, the threshold for the cathode capacity of the battery may be a value of the cathode capacity of the battery at which the proportion of the cathode capacity of the battery to the value obtained by multiplying the initial capacity of the battery by 1.1 is equal to 90%, but is not limited thereto.

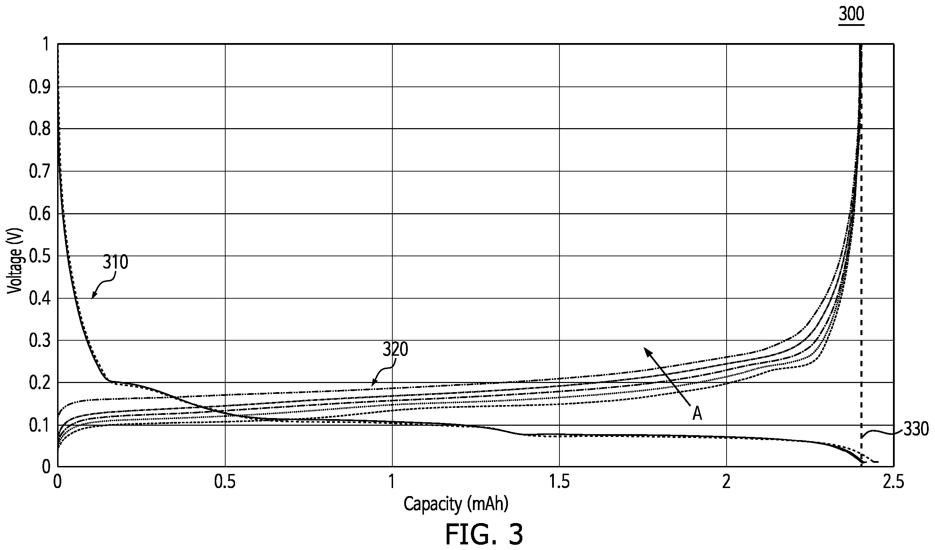

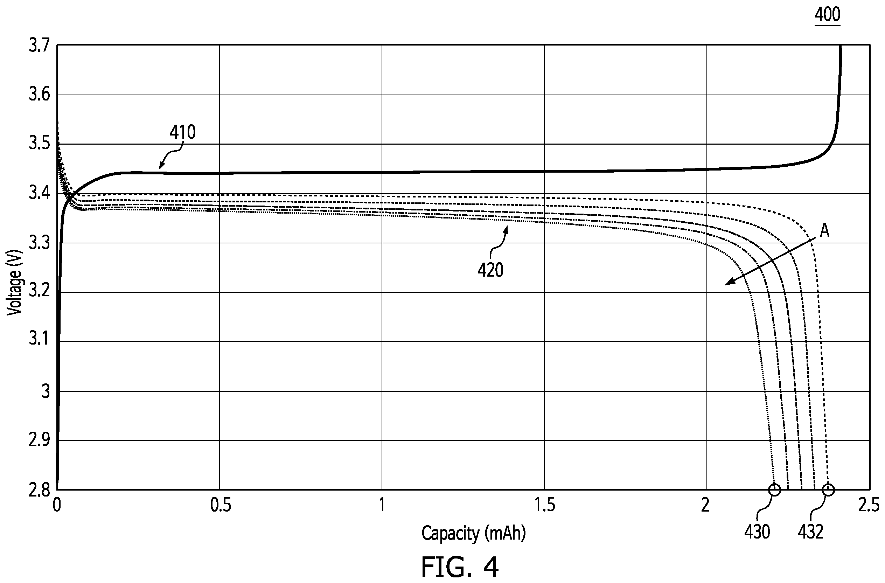

FIG. 3 shows an example of a charge/discharge capacity graph of an anode half-cell in accordance with some embodiments of the present disclosure. FIG. 4 shows an example of a charge/discharge capacity graph of a cathode half-cell in accordance with some embodiments of the present disclosure. Here, the half-cell may refer to a cell including a lithium metal, which may supply lithium ions necessary for a chemical reaction, as a reference electrode. The anode half-cell may be a half-cell including graphite as the anode. The electrochemical properties of the anode may be identified via experiments utilizing the anode half-cell and/or the like. The cathode half-cell may be a half-cell including lithium iron phosphate (LFP) as the cathode. The electrochemical properties of the cathode may be identified via experiments utilizing the cathode half-cell, etc.

The graph 300 illustrated in FIG. 3 is an example showing voltage data according to the charge/discharge capacity obtained by charging and discharging the anode half-cell. Specifically, the charge voltage data 310 of the anode half-cell may be obtained by maintaining the charge rate constant. In contrast, a plurality of discharge voltage data 320 for the anode half-cell may be obtained by varying the discharge rate. For example, first discharge voltage data may be discharge voltage data according to the discharge capacity of the anode half-cell obtained by discharging the anode half-cell at a discharge rate of 1 C. In contrast, second discharge voltage data may be discharge voltage data according to the discharge capacity of the anode half-cell obtained by discharging the anode half-cell at a discharge rate of 0.1 C. The discharge voltage data according to the discharge capacity of the anode half-cell shown in the graph 300 may be obtained by discharging the anode half-cell at discharge rates of 0.1 C to 1 C. The further in the A direction, the faster the discharge rate associated with the discharge voltage data may be.

Referring to FIG. 3, for the anode half-cell, it may be confirmed that the discharge capacity of the anode half-cell remains constant even if the discharge rate is increased or decreased (330). For example, it may be confirmed that the discharge capacity of the anode half-cell obtained by discharging the anode half-cell at a discharge rate of 1 C and the discharge capacity of the anode half-cell obtained by discharging the anode half-cell at a discharge rate of 0.1 C are the same (330). Further, it may be confirmed that the discharge capacities of a plurality of anode half-cells obtained by discharging the anode half-cells at discharge rates between 0.1 C and 1 C are likewise the same (330). From such experimental results, it may be estimated that the discharge capacity of the anode included in the full-cell will maintain a constant value even if the discharge rate of the full-cell changes.

The graph 400 illustrated in FIG. 4 is an example showing voltage data according to the charge/discharge capacity obtained by charging and discharging the cathode half-cell. Specifically, the charge voltage data 410 for the cathode half-cell may be obtained by maintaining the charge rate constant. In contrast, a plurality of discharge voltage data 420 for the cathode half-cell may be obtained by varying the discharge rate. For example, first discharge voltage data may be discharge voltage data according to the discharge capacity of the cathode half-cell obtained by discharging the cathode half-cell at a discharge rate of 1 C. Second discharge voltage data may be discharge voltage data according to the discharge capacity of the cathode half-cell obtained by discharging the cathode half-cell at a discharge rate of 0.1 C. The discharge voltage data according to the discharge capacity of the cathode half-cell shown in the graph 400 may be obtained by discharging the cathode half-cell at discharge rates of 0.1 C to 1 C. The further in the A direction, the faster the discharge rate associated with the discharge voltage data may be.

Referring to FIG. 4, for the cathode half-cell, it may be confirmed that the discharge capacity of the cathode half-cell also changes as the discharge rate increases or decreases. Therefore, it may be confirmed that the discharge capacity of the cathode half-cell obtained by discharging the cathode half-cell at a discharge rate between 0.1 C and 1 C decreases as the discharge rate increases. As a result, it may be confirmed that the change in discharge capacity according to the discharge rate is exhibited noticeably in the cathode.

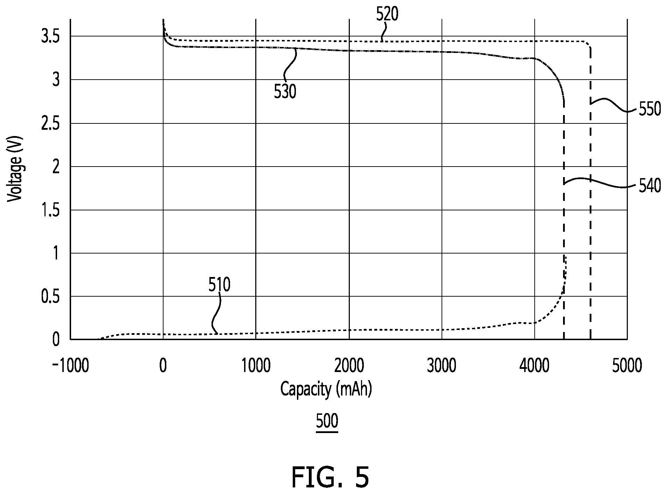

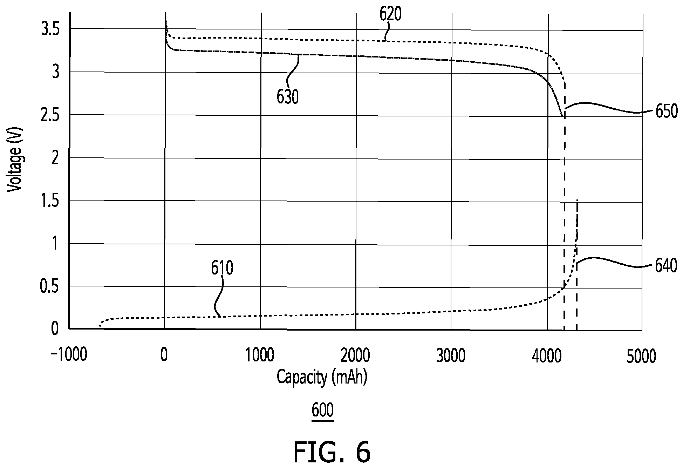

FIG. 5 shows an example of a discharge capacity graph at a low-rate discharge of an anode half-cell, a cathode half-cell, and a full-cell in accordance with some embodiments of the present disclosure. FIG. 6 shows an example of a discharge capacity graph at a high-rate discharge of an anode half-cell, a cathode half-cell, and a full-cell in accordance with some embodiments of the present disclosure.

Referring to FIG. 5, the graph 500 is an example showing voltage data according to capacity obtained by discharging an anode half-cell 510, a cathode half-cell 520, and a full-cell 530 at a low discharge rate. Here, the low discharge rate may be a discharge rate of 0.1 C to 0.5 C.

In the graph 500 shown in FIG. 5, the discharge capacity of the anode half-cell 510 may be the capacity of the anode half-cell 510 in the section where the capacity of the anode half-cell 510 no longer increases but the voltage of the anode half-cell 510 increases significantly during the process of discharging the anode half-cell 510. Further, the discharge capacity of the cathode half-cell 520 may be the capacity of the cathode half-cell 520 in the section, where the capacity of the cathode half-cell 520 no longer increases but the voltage of the cathode half-cell 520 decreases significantly during the process of discharging the cathode half-cell 520. Moreover, the discharge capacity of the full-cell 530 may be the capacity of the full-cell 530 in the section where the capacity of the full-cell 530 no longer increases but the voltage of the full-cell 530 decreases significantly during the process of discharging the full-cell 530.

Referring to the graph 500 shown in Fig. 5, if (e.g., when) the full-cell 530 is discharged at a low discharge rate, it may be confirmed that the graph representing the discharge capacity of the full-cell 530 and the graph representing the discharge capacity of the anode half-cell 510 are formed to correspond (540). Specifically, it may be confirmed that the capacity of the full-cell 530 in the section, where the capacity of the full-cell 530 no longer increases but the voltage of the full-cell 530 decreases significantly is almost coincident with the capacity of the anode half-cell 510 in the section where the capacity of the anode half-cell 510 no longer increases but the voltage of the anode half-cell 510 increases significantly (540). According to the graph 500 shown in Fig. 5, if (e.g., when) the full-cell 530 and the anode half-cell 510 are discharged at a low discharge rate, the discharge capacities of the full-cell 530 and the anode half-cell 510 may have values close to about 4300 mAh (540).

In contrast, if (e.g., when) the cathode half-cell 520 is discharged at a low discharge rate, it may be confirmed that the graph representing the discharge capacity of the full-cell 530 does not correspond to the graph representing the discharge capacity of the cathode half-cell 520. Specifically, it may be confirmed that the capacity of the full-cell 530 in the section, where the capacity of the full-cell 530 no longer increases but the voltage of the full-cell 530 decreases significantly is not coincident with the capacity of the cathode half-cell 520 in the section, where the capacity of the cathode half-cell 520 no longer increases but the voltage of the cathode half-cell 520 decreases significantly. According to the graph 500 shown in FIG. 5, if (e.g., when) the cathode half-cell 520 is discharged at a low discharge rate, the discharge capacity of the cathode half-cell 520 may have a value close to about 4600 mAh (550).

Referring to FIG. 6, the graph 600 is an example showing voltage data according to capacity obtained by discharging an anode half-cell 610, a cathode half-cell 620, and a full-cell 630 at a high discharge rate. Here, the high discharge rate may be a discharge rate of 0.5 C to 1 C.

In the graph 600 shown in FIG. 6, the discharge capacity of the anode half-cell 610 may be the capacity of the anode half-cell 610 in the section where the capacity of the anode half-cell 610 no longer increases but the voltage of the anode half-cell 610 increases significantly during the process of discharging the anode half-cell 610. Further, the discharge capacity of the cathode half-cell 620 may be the capacity of the cathode half-cell 620 in the section, where the capacity of the cathode half-cell 620 no longer increases but the voltage of the cathode half-cell 620 decreases significantly during the process of discharging the cathode half-cell 620. Moreover, the discharge capacity of the full-cell 630 may be the capacity of the full-cell 630 in the section, where the capacity of the full-cell 630 no longer increases but the voltage of the full-cell 630 decreases significantly during the process of discharging the full-cell 630.

Referring to the graph 600 shown in Fig. 6, if (e.g., when) the full-cell 630 is discharged at a high discharge rate, it may be confirmed that the graph representing the discharge capacity of the full-cell 630 and the graph representing the discharge capacity of the cathode half-cell 620 are formed to correspond (650). Specifically, it may be confirmed that the capacity of the full-cell 630 in the section, where the capacity of the full-cell 630 no longer increases but the voltage of the full-cell 630 decreases significantly is almost coincident with the capacity of the cathode half-cell 620 in the section, where the capacity of the cathode half-cell 620 no longer increases but the voltage of the cathode half-cell 620 decreases significantly (650). According to the graph 600 shown in FIG. 6, if (e.g., when) the full-cell 630 and the cathode half-cell 620 are discharged at a high discharge rate, the discharge capacities of the full-cell 630 and the cathode half-cell 620 may have values close to about 4200 mAh (650).

In contrast, if (e.g., when) the anode half-cell 610 is discharged at a high discharge rate, it may be confirmed that the graph representing the discharge capacity of the full-cell 630 does not correspond to the graph representing the discharge capacity of the anode half-cell 610. Specifically, it may be confirmed that the capacity of the full-cell 630 in the section, where the capacity of the full-cell 630 no longer increases but the voltage of the full-cell 630 decreases significantly is not coincident with the capacity of the anode half-cell 610 in the section, where the capacity of the anode half-cell 610 no longer increases but the voltage of the anode half-cell 610 increases significantly. According to the graph 600 shown in FIG. 6, if (e.g., when) the anode half-cell 610 is discharged at a high discharge rate, the discharge capacity of the anode half-cell 610 may have a value close to about 4300 mAh (640).

As a result, if (e.g., when) the full-cell 630 is discharged at a high discharge rate, it may be estimated that the discharge characteristics of the full-cell 630 are similar to the discharge characteristics of the cathode half-cell 620 discharged at a high discharge rate. Therefore, by inferring the discharge characteristics of the cathode half-cell 620 based on the discharge characteristics of the full-cell 630 discharged at a high discharge rate, the cathode capacity may be estimated utilizing only the discharge characteristics of the full-cell without decomposing the cathode into half-cells.

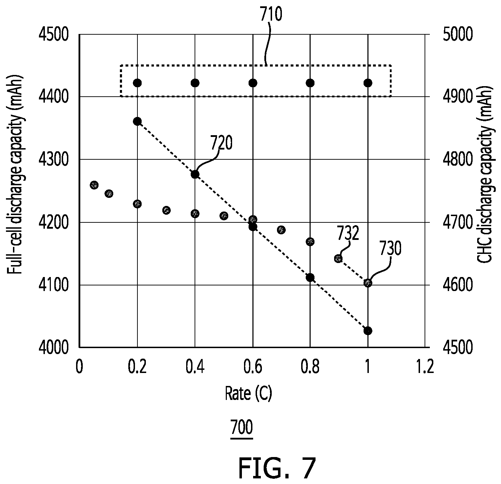

FIG. 7 is a graph showing an example of discharge data of a full-cell and a half-cell in accordance with some embodiments of the present disclosure.

Referring to Fig. 7, the graph 700 is an example showing discharge data obtained by discharging an anode half-cell 710, a cathode half-cell 720, and full-cells 730 and 732 at one or more discharge rates. Here, the discharge data may include the discharge capacity of a full-cell and/or a half-cell, which is associated with a discharge rate. Here, the discharge rate may be a discharge rate of 0.05 C to 1 C.

The full-cell may be a battery cell including a cathode and an anode. The cathode of the full-cell may include lithium iron phosphate (LFP), and the anode of the full-cell may include graphite. The half-cell may refer to a cell including a lithium metal, which may infinitely supply lithium ions, as a reference electrode. Here, the half-cell may refer to a coin half-cell (CHC). The anode half-cell may be a half-cell including graphite as the anode. The electrochemical properties of the anode may be identified via the anode half-cell. The cathode half-cell may be a half-cell including lithium iron phosphate (LFP) as the cathode. The electrochemical properties of the cathode may be identified via the cathode half-cell.

Referring to the graph 700 shown in FIG. 7, the discharge data of the anode half-cell according to the discharge rate of the anode half-cell may be checked (710). For the anode half-cell, it may be confirmed that the discharge capacity of the anode half-cell maintains a value in a certain section even if the discharge rate of the anode half-cell varies. Specifically, if (e.g., when) the anode half-cell is discharged at a discharge rate of 0.2 C, it may be confirmed that the discharge capacity of the anode half-cell is about 4920 mAh. Further, if (e.g., when) the anode half-cell is discharged at a discharge rate of 0.6 C, it may be confirmed that the discharge capacity of the anode half-cell is about 4930 mAh. Moreover, if (e.g., when) the anode half-cell is discharged at a discharge rate of 1 C, it may be confirmed that the discharge capacity of the anode half-cell is about 4930 mAh. It may be confirmed that the discharge capacity of the anode half-cell maintains a value in a corresponding section (e.g., 4920 mAh to 4930 mAh) even if the discharge rate of the anode half-cell increases from 0.2 C to 0.6 C or from 0.6 C to 1 C. As a result, it may be confirmed that the discharge rate of the anode half-cell has little relevance to the discharge capacity of the anode half-cell.

Referring to the graph 700 shown in FIG. 7, the discharge data of the cathode half-cell according to the discharge rate of the cathode half-cell may be checked (720). For the cathode half-cell 720, it may be confirmed that there is a linear relationship between the discharge rate of the cathode half-cell and the discharge capacity of the cathode half-cell. Specifically, if (e.g., when) the cathode half-cell is discharged at a discharge rate of 0.2 C, it may be confirmed that the discharge capacity of the cathode half-cell is about 4860 mAh. Further, if (e.g., when) the cathode half-cell is discharged at a discharge rate of 0.6 C, it may be confirmed that the discharge capacity of the cathode half-cell is about 4700 mAh. Moreover, if (e.g., when) the cathode half-cell is discharged at a discharge rate of 1 C, it may be confirmed that the discharge capacity of the cathode half-cell is about 4540 mAh. Therefore, it may be confirmed that the discharge capacity of the cathode half-cell decreases by 160 mAh from 4860 mAh to 4700 mAh as the discharge rate of the cathode half-cell increases by 0.4 C from 0.2 C to 0.6 C, and the discharge capacity of the cathode half-cell decreases by 160 mAh from 4700 mAh to 4540 mAh as the discharge rate of the cathode half-cell increases by 0.4 C from 0.6 C to 1 C. As a result, it may be confirmed that there is a linear relationship between the discharge rate of the cathode half-cell and the discharge capacity of the cathode half-cell.

Referring to the graph 700 shown in Fig. 7, discharge data according to the discharge rate of the full-cell may be checked (730, 732). For the full-cell, it may be confirmed that there is a linear relationship between the discharge rate of the full-cell and the discharge capacity of the full-cell in the section, where the discharge rate of the full-cell is high, which has a slope similar to the slope of the linear graph that exists between the discharge rate of the cathode half-cell and the discharge capacity of the cathode half-cell. Specifically, if (e.g., when) the full-cell is discharged at a discharge rate of 1 C, it may be confirmed that the discharge capacity of the full-cell is about 4110 mAh (730). Further, if (e.g., when) the full-cell is discharged at a discharge rate of 0.9 C, it may be confirmed that the discharge capacity of the full-cell is about 4150 mAh (732). Moreover, if (e.g., when) the full-cell is discharged at a discharge rate of 0.8 C, it may be confirmed that the discharge capacity of the full-cell is about 4180 mAh. Therefore, in the section where the discharge rate of the full-cell is 0.9 C to 1 C, it may be confirmed that the slope value of the discharge capacity of the full-cell versus the discharge rate of the full-cell is -400 (mAh/C), which is the same as the slope value of the discharge capacity of the cathode half-cell versus the discharge rate of the cathode half-cell. Referring to the graph 700 shown in FIG. 7, it may be confirmed that as the discharge rate of the full-cell decreases, the difference between the slope value of the discharge capacity of the full-cell relative to the discharge rate of the full-cell and the slope value of the discharge capacity of the cathode half-cell relative to the discharge rate of the cathode half-cell increases. Therefore, the cathode capacity of the battery may be calculated by estimating a linear function that represents the relationship between the discharge rate of the full-cell and the discharge capacity of the full-cell based on the discharge data associated with the discharge rate of the full-cell, which has a slope value similar to the slope value of the discharge capacity of the cathode half-cell relative to the discharge rate of the cathode half-cell.

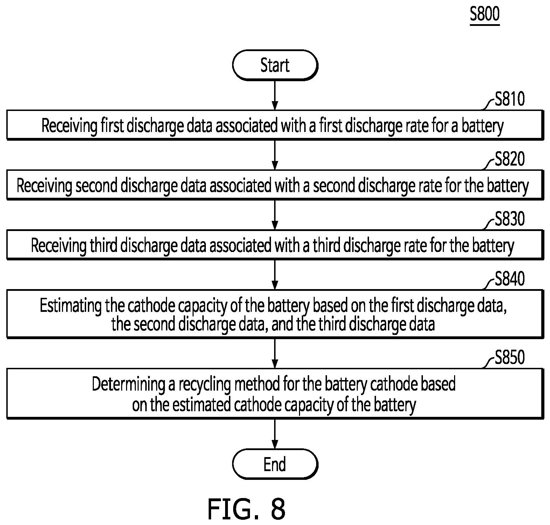

FIG. 8 is a flowchart showing an example of a method for estimating a cathode capacity (S800) in accordance with some embodiments of the present disclosure. The method for estimating a cathode capacity (S800) may be performed by at least one processor. First, the method for estimating a cathode capacity (S800) may begin by the processor receiving first discharge data associated with a first discharge rate for a battery from a data measurement part (S810). In some embodiments, the first discharge rate may be the maximum discharge rate of the battery. Here, the maximum discharge rate of the battery may be a maximum discharge rate allowed according to the performance of the battery. For example, the maximum discharge rate of the battery may be 1 C.

Thereafter, the processor may receive second discharge data associated with a second discharge rate for the battery from the data measurement part (S820). Further, the processor may receive third discharge data associated with a third discharge rate for the battery from the data measurement part (S830).

In some embodiments, the first discharge data associated with the first discharge rate may include data on the discharge capacity of the battery obtained by discharging the fully charged battery at the first rate. The second discharge data associated with the second discharge rate may include data on the discharge capacity of the battery obtained by discharging the fully charged battery at the second rate. The third discharge data associated with the third discharge rate may include data on the discharge capacity of the battery obtained by discharging the fully charged battery at the third rate.

In some embodiments, the first discharge rate, the second discharge rate, and the third discharge rate may be different from each other (e.g., the first discharge rate, the second discharge rate, and the third discharge rate are not the same). For example, the first discharge rate may be faster than the second discharge rate. Further, the second discharge rate may be faster than the third discharge rate.

In some embodiments, the first discharge rate, the second discharge rate, and the third discharge rate may be rates greater than or equal to a proportion (e.g., the predetermined proportion) of the maximum discharge rate of the battery. For example, the first discharge rate, the second discharge rate, and the third discharge rate may be greater than or equal to a proportion of the maximum discharge rate allowed according to the performance of the battery. For example, the maximum discharge rate of the battery may be 1 C. Here, the proportion may be 50%. Therefore, the first discharge rate, the second discharge rate, and the third discharge rate may be 0.5 C or higher.

In some embodiments, each discharge data (e.g., the first discharge data, the second discharge data, and the third discharge data) may include data on the discharge capacity of a battery full-cell associated with each discharge rate (e.g., the first discharge rate, the second discharge rate, and the third discharge rate, respectively).

Thereafter, the processor may estimate the cathode capacity of the battery based on the first discharge rate, the second discharge rate, the third discharge rate, the first discharge data, the second discharge data, and the third discharge data (S840). As a result, the cathode capacity of the battery may be estimated utilizing data on the battery full-cell without dismantling and/or disassembling the battery. In some embodiments, the cathode of the battery may include lithium iron phosphate (LFP).

Thereafter, the processor may determine a recycling method for the battery cathode based on the estimated cathode capacity of the battery (S850). Here, the recycling method for the battery cathode may include a direct recycling method, a pyrometallurgical method, and/or a hydrometallurgical method.

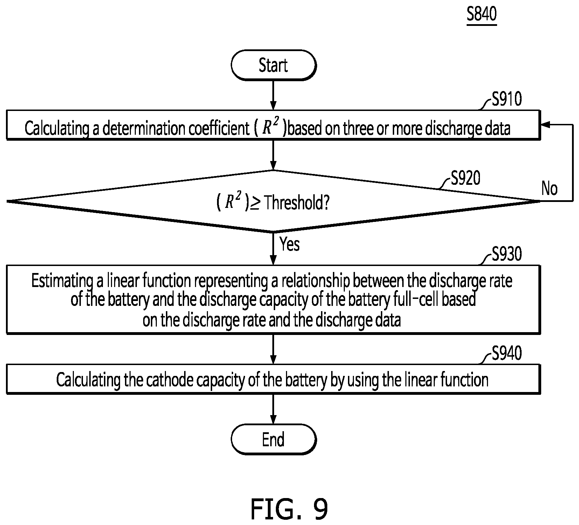

FIG. 9 is a flowchart showing an example of a step of estimating a cathode capacity of a battery (S840) in accordance with some embodiments of the present disclosure. The step S840 may begin with calculating a determination coefficient (*R*²) based on three or more discharge data (S910). Here, the three or more discharge data (e.g., the first discharge data, the second discharge data, and the third discharge data) may be data associated with different discharge rates, respectively (e.g., the first discharge rate, the second discharge rate, and the third discharge rate, respectively). For example, the three or more discharge data may include the first discharge data associated with the first discharge rate, the second discharge data associated with the second discharge rate, and the third discharge data associated with the third discharge rate. Further, the determination coefficient may be a measure representing the degree to which an estimated linear model is suitable for given data. The determination coefficient may have a value between 0 and 1, and the higher the correlation between the dependent variable and the independent variable, the closer the value may be to 1. Therefore, the higher the determination coefficient, the higher the accuracy of the estimated linear model may be.

In some embodiments, the processor may determine whether the calculated determination coefficient is greater than or equal to a threshold (e.g., a predetermined threshold) (S920). For example, the threshold may be 0.99. In response to determining that the determination coefficient is less than the threshold (No), the processor may receive fourth discharge data associated with a fourth discharge rate for the battery. Thereafter, a new determination coefficient may be calculated based on the first discharge rate, the second discharge rate, the fourth discharge rate, the first discharge data, the second discharge data, and the fourth discharge data. Further, the processor may determine whether the new determination coefficient is greater than or equal to the threshold (S910). Here, the fourth discharge data may be discharge data associated with the fourth discharge rate. Moreover, the third discharge rate may be less than the first discharge rate, the second discharge rate, and the fourth discharge rate. For example, in response to determining that the determination coefficient is less than the threshold, the processor may calculate a determination coefficient based on discharge data associated with a higher discharge rate instead of the discharge data associated with the lowest discharge rate. This process may be performed repetitively until it is determined that the determination coefficient calculated based on the discharge data associated with the three or more discharge rates is greater than or equal to the threshold.

In some embodiments, in response to determining that the determination coefficient is greater than or equal to the threshold (Yes), the processor may estimate a linear function representing a relationship between the discharge rate of the battery and the discharge capacity of the battery full-cell based on the discharge rate of the battery and the discharge data associated therewith (S930). Here, the discharge rate of the battery and the discharge data associated therewith may refer to three or more discharge rates and discharge data associated therewith that are based on if (e.g., when) the determination coefficient is determined to be greater than or equal to the threshold.

Thereafter, the processor may calculate the cathode capacity of the battery by utilizing the estimated linear function representing the relationship between the discharge rate of the battery and the discharge capacity of the battery full-cell (S940). In some embodiments, the cathode capacity of the battery may be calculated based on the discharge capacity of the battery full-cell associated with the discharge rate of 0 C via the estimated linear function.

In some embodiments, the cathode of the battery may include lithium iron phosphate (LFP). Further, the cathode of the battery may include LiCoPO₄, LiMnPO₄, LiNiPO₄, NaFePO₄, and/or suitable composite materials thereof.

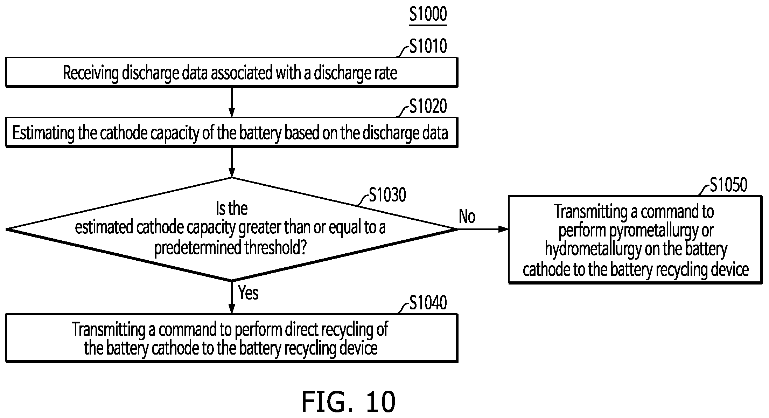

FIG. 10 is a flowchart showing an example of a process for determining a recycling method for a battery cathode in accordance with some embodiments of the present disclosure.

The method (S1000) may begin with a processor receiving discharge data associated with a discharge rate (S1010). Thereafter, the processor may estimate the cathode capacity of the battery based on the discharge rate and the discharge data associated therewith (S1020). Further, the processor may determine whether the estimated cathode capacity is greater than or equal to a threshold (S1030).

Thereafter, in response to determining that the cathode capacity of the battery is greater than or equal to the threshold (Yes), the processor may transmit a command to perform direct recycling of the battery cathode to the battery recycling device (S1040). In contrast, in response to determining that the cathode capacity of the battery is less than the threshold (No), the processor may transmit a command to perform pyrometallurgy or hydrometallurgy on the battery cathode to the battery recycling device (S1050). For example, the threshold for the cathode capacity of the battery may be a value of the cathode capacity of the battery, at which the proportion of the cathode capacity of the battery to the value obtained by multiplying the initial capacity of the battery by 1.1 is equal to 90%. Here, the initial capacity of the battery may refer to the capacity of the battery immediately after it is manufactured (Beginning of Life; BoL).

The flowcharts in FIGS. 8 to 10 and the foregoing descriptions are merely examples of the present disclosure, and the scope of the present disclosure is not limited to the flowcharts in FIGS. 8 to 10 and the foregoing descriptions. For example, one or more steps in the flowcharts and the foregoing descriptions may be added/modified/deleted, the order of one or more steps may be changed, and one or more steps may be performed simultaneously.

Although the present disclosure has been described above with respect to embodiments thereof, the present disclosure is not limited thereto. One or more modifications and variations may be made thereto by those skilled in the art within the scope of the present disclosure and the equivalent scope of the appended claims.

### Description of Symbols

100: Battery recycling system
110: Battery
120: Data measurement part
130: Charging/discharging device
140: Information processing system
142: Processor
144: Memory
150: Battery recycling device

## Claims

1. A method (S800) for estimating a cathode capacity, carried out by a processor (142, 200), comprising:
receiving (S810) first discharge data associated with a first discharge rate of a battery (110);
receiving (S820) second discharge data associated with a second discharge rate of the battery (110);
receiving (S830) third discharge data associated with a third discharge rate of the battery (110); and
estimating (S840) the cathode capacity of the battery (110) based on the first discharge rate, the second discharge rate, the third discharge rate, the first discharge data, the second discharge data, and the third discharge data,
wherein the first discharge rate, the second discharge rate, and the third discharge rate are different from each other.

2. The processor-implemented method (S800) as claimed in claim 1, wherein the first discharge rate comprises a maximum discharge rate of the battery (110).

3. The processor-implemented method (S800) as claimed in claim 1, wherein the first, second, and third discharge data comprise a discharge capacity of a battery full-cell (530, 630) associated with the first, second, and third discharge rates, respectively.

4. The processor-implemented method (S800) as claimed in claim 1, wherein the first discharge rate, the second discharge rate, and the third discharge rate are greater than or equal to a proportion of a maximum discharge rate of the battery (110).

5. The processor-implemented method (S800) as claimed in one of the preceding claims, wherein the estimating (S840) of the cathode capacity of the battery (110) comprises:
estimating (930) a linear function representing a relationship between a discharge rate of the battery (110) and a discharge capacity of a battery full-cell (530, 630) based on the first discharge rate, the second discharge rate, the third discharge rate, the first discharge data, the second discharge data, and the third discharge data.

6. The processor-implemented method (S800) as claimed in claim 5, wherein the estimating (S840) of the cathode capacity of the battery (110) further comprises:
calculating (S910) a first determination coefficient based on the first discharge rate, the second discharge rate, the third discharge rate, the first discharge data, the second discharge data, and the third discharge data; and
determining (S920) whether the first determination coefficient is greater than or equal to a threshold.

7. The processor-implemented method (S800) as claimed in claim 6, wherein the estimating (S840) of the cathode capacity of the battery (110) further comprises:
receiving fourth discharge data associated with a fourth discharge rate for the battery (110) in response to determining that the first determination coefficient is less than the threshold;
calculating (S910) a second determination coefficient based on the first discharge rate, the second discharge rate, the fourth discharge rate, the first discharge data, the second discharge data, and the fourth discharge data; and
determining (S920) whether the second determination coefficient is greater than or equal to the threshold, and
wherein the third discharge rate is less than the first discharge rate, the second discharge rate, and the fourth discharge rate.

8. The processor-implemented method (S800) as claimed in at least one of claims 5 to 7, wherein the estimating (S840) of the cathode capacity of the battery (110) further comprises:
calculating (S940) the cathode capacity of the battery (110) based on the linear function.

9. The processor-implemented method (S800) as claimed in at least one of claims 5 to 8, wherein the linear function is estimated via an extrapolation.

10. The processor-implemented method (S800) as claimed in at least one of the preceding claims, further comprising:
determining (S850) a recycling method for a cathode of the battery (110) based on the estimated cathode capacity of the battery (110).

11. The processor-implemented method (S800) as claimed in claim 10, wherein the determining (S850) of the recycling method for the cathode of the battery (110) comprises:
determining (S1030) that the estimated cathode capacity of the battery (110) is greater than or equal to a threshold; and
transmitting (S1040) a command to perform a direct recycling of the cathode of the battery (110) to a battery recycling device (150) in response to the determining that the estimated cathode capacity of the battery (110) is greater than or equal to the threshold.

12. The processor-implemented method (S800) as claimed in claim 10, wherein the determining of the recycling method for the cathode of the battery (110) comprises:
determining (S1030) that the estimated cathode capacity of the battery (110) is less than a threshold; and
transmitting (S1050) a command to perform pyrometallurgy or hydrometallurgy on the cathode of the battery (110) to a battery recycling device (150) in response to the determining that the estimated cathode capacity of the battery (110) is less than the threshold.

13. A battery recycling system (100) comprising:
a memory (144); and
a processor (142, 200) connected to the memory (144) and configured to execute instructions stored in the memory (144) to cause the processor (142, 200) to perform the method (S800) according to one of the preceding claims, comprising:
receiving (S810) first discharge data associated with a first discharge rate of a battery (110);
receiving (S820) second discharge data associated with a second discharge rate of the battery (110);
receiving (S830) third discharge data associated with a third discharge rate of the battery (110); and
estimating (S840) a cathode capacity of the battery (110) based on the first discharge rate, the second discharge rate, the third discharge rate, the first discharge data, the second discharge data, and the third discharge data, and
wherein the first discharge rate, the second discharge rate, and the third discharge rate are different from each other.

14. The battery recycling system (100) as claimed in claim 13, further comprising:
a battery recycling device (150),
wherein the instructions cause the processor (142, 200) to perform the method (S800), which further comprises:
determining (S850) a recycling method for a cathode of the battery (110) based on the estimated cathode capacity of the battery (110), and
transmitting (S1040, S1050) a command related to the determined recycling method to the battery recycling device (150).
